(19) Europäisches Patentamt
European Patent Office
Office européen des brevets

(11) Numéro de publication: **0 423 033 A1**

(12) # DEMANDE DE BREVET EUROPEEN

(21) Numéro de dépôt: **90402842.0**

(22) Date de dépôt: **11.10.90**

(51) Int. Cl.5: **G01R 33/24**, G01C 19/60, C07B 61/02, C07D 207/46

(30) Priorité: **13.10.89 FR 8913422**

(43) Date de publication de la demande: **17.04.91 Bulletin 91/16**

(84) Etats contractants désignés: **DE FR GB**

(71) Demandeur: **COMMISSARIAT A L'ENERGIE ATOMIQUE Etablissement de Caractère Scientifique Technique et Industriel**
**31/33, rue de la Fédération**
**F-75015 Paris(FR)**

Demandeur: **TOTAL Compagnie Française des Pétroles**
**5 rue Michel-Ange**
**F-75016 Paris(FR)**

(72) Inventeur: **Salvi, Charles**
**73Bis, Cours Jean Jaurès**
**F-38000 Grenoble(FR)**
Inventeur: **Fabre, Claude**
**87 rue de Paris**
**F-92190 Meudon(FR)**
Inventeur: **Rassat, André**
**37 rue de Tournefort**
**F-75005 Paris(FR)**
Inventeur: **Chiarelli, Robert**
**159 Avenue du Général Leclerc**
**F-92340 Bourg la Reine(FR)**

(74) Mandataire: **Mongrédien, André et al**
**c/o BREVATOME 25, rue de Ponthieu**
**F-75008 Paris(FR)**

(54) **Procédé de polarisation des noyaux d'un solvant utilisable en magnétométrie ou en gyrométrie, à une température de 30 a 130 c, procédé de préparation des radicaux nitroxydes utilisés dans ce procédé et sonde de magnétomètre utilisant ce procédé.**

(57) L'invention concerne un procédé de polarisation des noyaux d'un solvant en magnétométrie ou gyrométrie, utilisant un radical nitroxyde répondant à la formule :

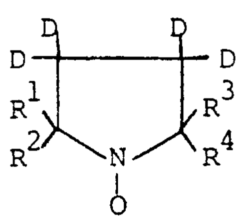

(I)

dans laquelle R , $R^2$, $R^3$ et $R^4$ qui peuvent être identiques ou différents, représentent de préférence CD3,et N représente $^{14}N$ ou $^{15}N$.

Pour des températures de 30 à 130° C, le solvant utilisé est de préférence l'eau ou un mélange eau-Diglyme ou eau-dioxanne. Ce radical en solution dans un tel solvant peut être utilisé comme échantillon 8 dans une sonde de magnétomètre sans axe interdit.

EP 0 423 033 A1

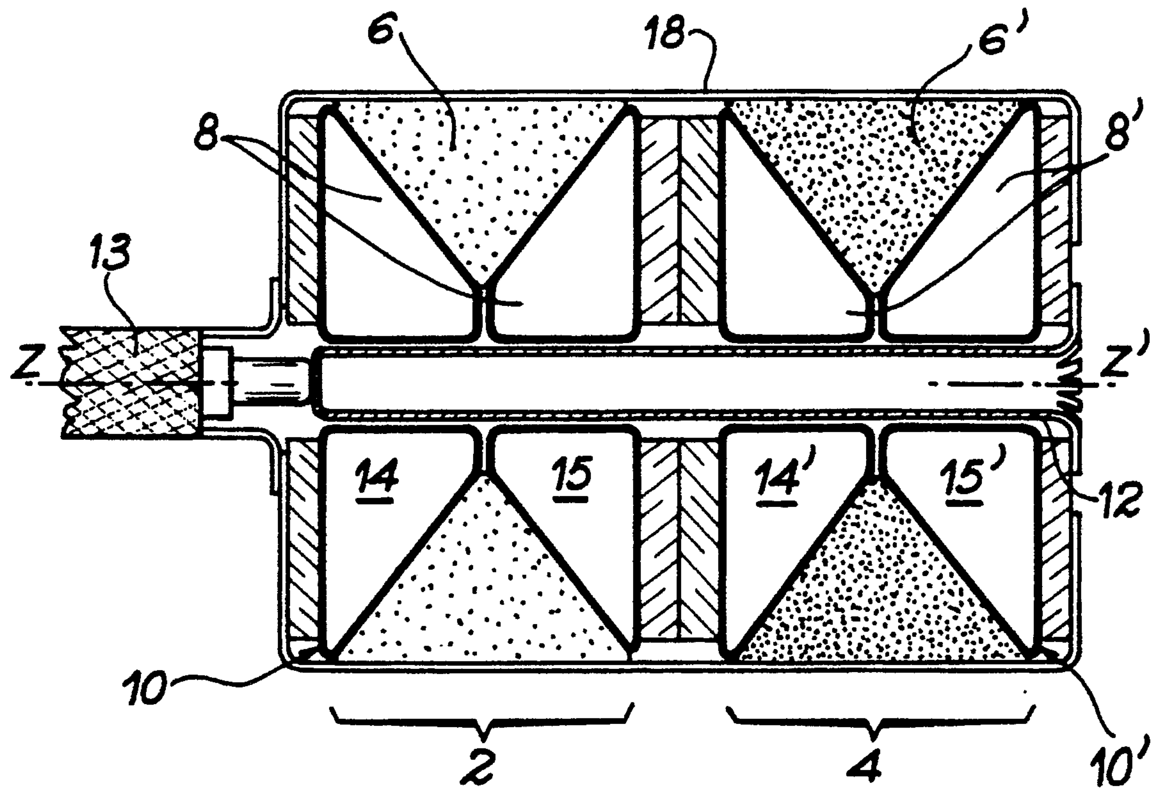


FIG. 1

# PROCÉDÉ DE POLARISATION DES NOYAUX D'UN SOLVANT UTILISABLE EN MAGNÉTOMÉTRIE OU EN GYROMÉTRIE, À UNE TEMPÉRATURE DE 30 À 130°C, PROCÉDÉ DE PRÉPARATION DES RADICAUX NITROXYDES UTILISÉS DANS CE PROCÉDÉ ET SONDE DE MAGNÉTOMÈTRE U ILISANT CE PROCÉDÉ.

La présente invention a pour objet un procédé de polarisation des noyaux d'un solvant utilisant un radical libre dissous dans ce solvant.

De façon plus précise, elle concerne la magnétométrie et la gyrométrie en champ magnétique faible, utilisant les techniques de la résonance magnétique nucléaire (RMN) avec polarisation dynamique des noyaux d'un solvant.

On sait que dans les magnétomètres à champ terrestre et les gyromètres utilisant la résonance magnétique des noyaux, le principal problème est celui de la polarisation, c'est-à-dire de l'orientation forcée des spins, ou moments cinétiques des noyaux, notamment des protons du solvant dans lequel le radical est dissous en proportion convenable.

Cette polarisation peut être obtenue, conformément au brevet français n° 1 174 136 intitulé : "Perfectionnement aux méthodes de mesure des champs magnétiques faibles par résonance magnétique" déposé le 6 avril 1957, au nom du demandeur, par couplage de l'électron non apparié d'un radical libre, dont la raie de résonance paramagnétique électronique est saturée par un champ de haute fréquence convenable, avec les noyaux du solvant.

Les magnétomètres à résonance magnétique nucléaire fonctionnant sur ce principe tels que ceux décrits dans FR-A- 1 447 226 et FR-A- 2 098 624, sont des magnétomètres très performants pour la mesure des champs magnétiques faibles.

Comme ils sont isotropes, c'est-à-dire qu'ils permettent de connaître directement la valeur du module du champ magnétique, indépendamment de la direction du capteur par rapport à celle du vecteur qu'ils mesurent, ils peuvent trouver des applications dans de nombreux domaines réclamant une haute sensibilité, tels que :

- la recherche d'épaves en mer, de pipelines,
- la cartographie magnétique de sites archéologiques,
- la surveillance de volcans,
- la stratigraphie magnétique en puits de forage, et
- le domaine militaire.

Ces magnétomètres à résonance magnétique nucléaire à couplage de spin comprennent généralement une tête ou capteur dans laquelle des bobines sont associées à au moins un échantillon de matière à propriété gyromagnétique et reliées à l'entrée et à la sortie d'un amplificateur linéaire pour constituer une boucle dans laquelle on mesure la fréquence d'oscillation nucléaire.

L'échantillon de matière à propriété gyromagnétique est constitué par une substance paramagnétique telle qu'un radical libre comportant un électron non aparié en solution dans un solvant comportant des noyaux atomiques à moment magnétique et moment cinétique non nuls.

Des solvants utilisables sont par exemple des alcools et des éthers tels que le méthanol, l'octanol, l'éthylène glycol et le diméthoxy éthane.

Des radicaux libres utilisables sont décrits par exemple dans EP-A- 0 185 825, FR-A-2 063 416 et US-A- 3 966 409. Parmi ceux-ci, on utilise en particulier les composés du EP-A- 0 185 825, qui répondent aux formules suivantes :

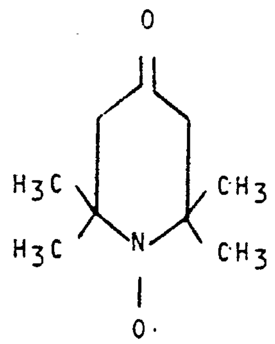

2,2,6,6-tétra-méthyl-4pipéri-dinone-1-oxyle, dénommé ci-après "TANO"

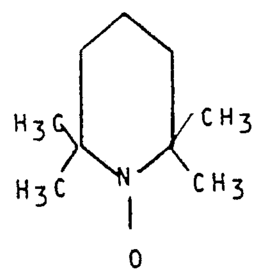

2,2,6,6-tétra-méthyl-pipéri-dine-1-oxyle, dénommé ciaprès "TANANE"

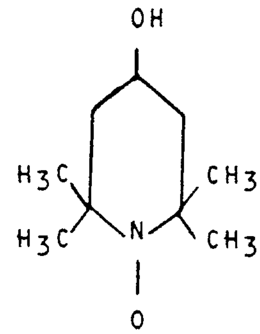

2,2,6,6-tétraméthyl pipéridirol-1-oxyle dénommé ci-après "TANOL"

dans lesquelles les atomes d'hydrogène peuvent être totalement ou partiellement remplacés par des atomes de deutérium, et l'azote peut être de l'azote 14 ou de l'azote 15.

Jusqu'à présent, les meilleurs résultats pour la magnétométrie et la gyrométrie, ont été obtenus avec les radicaux TANO 15D, soit le TANO décrit ci-dessus complètement deutéré avec $^{15}N$, et TANANE 15, soit le TANANE décrit ci-dessus avec $^{15}N$.

Cependant, ces radicaux libres ne conviennent pas complètement pour une utilisation dans le domaine pétrolier lorsque les profondeurs de forage atteignent 4 000 m.

En effet, dans ces conditions, avec un gradient géothermique moyen de 2° C/100m, les températures de fond de puits peuvent atteindre 80 à 120° C selon la nature du sol et la proximité des sources chaudes, et les magnétomètres actuels utilisant les radicaux Tano et Tanane répondant aux formules données ci-dessus ne peuvent résister à ces températures supérieures à 70° C, pour les raisons suivantes :

1°) la résistance mécanique du capteur est insuffisante dès que l'on dépasse la température de 70° C,

2°) on observe une perte d'amplitude du signal en résonance magnétique nucléaire (RMN) liée à l'élévation de la température, et

3°) les solutions de radicaux libres utilisées se dégradent chimiquement de façon irréversible au delà de 70° C.

En effet, dans les magnétomètres à RMN, le radical libre est en solution dans un solvant disposé dans un flacon en verre. Or, les solvants utilisés, par exemple le méthanol et le diméthoxyéthane, ont des points d'ébullition respectivement situés à 64,5° C et 85° C. Aussi, si l'on soumet la solution à des températures supérieures au point d'ébullition du solvant, il va se produire une augmentation de la pression dans le flacon de verre la contenant et, au delà de la résistance mécanique du verre, il y aura rupture et éclatement des parois du flacon. Lorsqu'on dépasse le point d'ébullition, la pression croît très rapidement car elle a pour expression approchée :

$$\log_{10} P = -\frac{0,05223a}{T} + b$$

dans laquelle a et b sont des coefficients propres aux solvants, p est la pression et T est la tempéra ture.

Ainsi, avec les solvants utilisés, cette pression peut atteindre 0,35MPa à 100° C, et il est clair que l'épaisseur de verre nécessaire pour résister à une telle pression est supérieure aux épaisseurs maximales envisageables dans un magnétomètre.

Par ailleurs, la résistance mécanique du flacon risque d'être insuffisante en raison de la dilatation du solvant. En effet, si la température T du liquide augmente, le volume V occupé par celui-ci évolue également selon la loi générale :

$V_{T2} = V_{T1} (1 + \alpha_{T1T2} \Delta T)$ pour $0<\Delta T<10$

$V_{T2} = V_{T1} (1 + \alpha \Delta T + \beta \Delta T2 + \nu \Delta T3)$ pour $\Delta T>10$.

Pour absorber cette dilatation, on prévoit généralement une bulle de dilatation dans le flacon contenant

la solution. Pour des magnétomètres ne dépassant pas 70°C, le volume de cette bulle est de 10 à 12% du volume de solvant mais il devrait atteindre 25% pour des températures de 120°C. Ceci a deux conséquences néfastes car, d'une part, on a une perte de volume utile à faible température, d'autre part, on modifie localement le coefficient diélectrique dans la cavité à haute fréquence. Il en résulte une modification de l'impédance de cette cavité en fonction de la position de la bulle et de la température qui sera d'autant plus marquée que la bulle sera grande. Aussi, il est difficilement envisageable de prévoir un volume de bulle aussi important.

La température a également un effet sur le signal de résonance magnétique nucléaire qui perd de l'amplitude lorsque la température augmente. Cette perte est attribuable à deux phénomènes principaux qui sont, d'une part, la chute du vecteur d'aimantation $M_0$ ou composante selon la direction du champ appliqué auquel sont soumis les protons à l'équilibre thermodynamique, et, d'autre part, la chute du facteur de polarisation dynamique.

Le choix d'un solvant approprié permet de pallier partiellement à cette perte d'amplitude du signal RMN tout au moins dans la gamme de températures exploitées.

Lorsque le magnétomètre fonctionne à une température élevée telle que 130°C, on peut observer, par ailleurs, une dégradation chimique de la solution due à une réaction entre le solvant et le radical libre. En effet, lorsque la température s'élève, l'agitation thermodynamique devient telle que la molécule du radical libre possédant un électron non aparié est soumise à des chocs intermoléculaires violents. Cette agitation moléculaire a pour conséquence de permettre à l'électron non aparié de se recombiner avec le milieu. Il en résulte une disparition des électrons non apariés permettant la polarisation dynamique. Ainsi, après un stage de 10 heures à 130°C, on observe une dégénérescence des radicaux dissous très importante lorsque ceux-ci sont constitués par du TANO 15D. De plus, ce phénomène est irréversible et seul le remplacement de la solution peut résoudre le problème.

La présente invention a précisément pour objet un procédé de polarisation des noyaux d'un solvant utilisant des radicaux nitroxydes et des solvants stables à une température de 30 à 130°C, qui permet de pallier les inconvénients décrits ci-dessus.

Selon l'invention, le procédé de polarisation magnétique en champ faible des noyaux d'un solvant, à une température de 30 à 130°C, par saturation d'une raie de résonance magnétique électronique d'un radical libre à structure spectrale hyperfine dissous dans ce solvant, en magnétométrie et en gyrométrie, se caractérise en ce que le radical libre est un radical nitroxyde répondant à la formule :

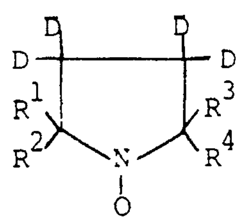

(I)

dans laquelle $R^1$, $R^2$, $R^3$ et $R^4$ qui peuvent être identiques ou différents, représentent un radical alkyle ou un radical alcoxy éventuellement deutéré, ou dans laquelle les couples $R^1$ - $R^2$ et/ou $R^3$ - $R^4$ forment ensemble un radical cycloalkyle ou polycycloalkyle éventuellement deutéré, et N représente $^{14}N$ ou $^{15}N$.

Les radicaux alkyle et alcoxy utilisables dans l'invention peuvent être des radicaux linéaires ou ramifiés ayant de 1 à 5 atomes de carbone, dont tout ou partie des atomes d'hydrogène peuvent être remplacés par des atomes de deutérium D.

Lorsque $R^1$-$R^2$ et/ou $R^3$-$R^4$ forment ensemble un radical cycloalkyle, celui-ci a de préférence 4 à 11 atomes de carbone.

Lorsque $R^1$-$R^2$ et/ou $R^3$-$R^4$ forment ensemble un radical polycycloalkyle, il peut s'agir de radicaux mantyles.

De préférence, selon l'invention, $R^1$, $R^2$, $R^3$ et $R^4$ sont des radicaux alkyle deutérés ayant de 1 à 4 atomes de carbone, par exemple les radicaux méthyle, éthyle, isopropyle et tertiobutyle, deutérés.

Selon un mode préféré de réalisation de l'invention, le radical nitroxyde répond à la formule :

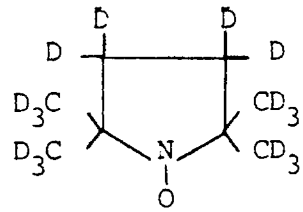

(II)

dans laquelle l'atome d'azote est de l'azote 14 ou de l'azote 15.

Dans le radical nitroxyde de l'invention, la présence des atomes de deutérium et le remplacement éventuel de l'azote-14 par l'azote-15 permettent d'améliorer de façon importante, comme on le verra plus loin, les caractéristiques RPE (largeur de raie et amplitude du signal) du radical par rapport au radical non deutéré décrit dans FR-A- 1 376 628.

De plus, le radical de l'invention qui comporte un cycle à 5 atomes de carbone, a une stabilité à la température meilleure que celle des radicaux ayant un cycle à 6 atomes de carbone, ce qui n'était ni décrit, ni suggéré par ce document antérieur.

Aussi, le radical de l'invention est intéressant pour une utilisation à des températures de 30° C à 130° C.

Les radicaux nitroxydes de l'invention peuvent être préparés par des procédés classiques en partant du bromhydrate de formule :

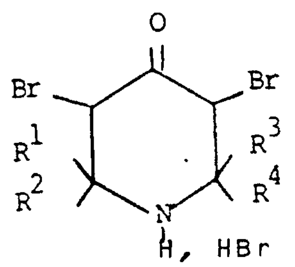

(III)

Dans ce cas, on soumet ce bromhydrate à un réarrangement de Favorsky dans l'ammoniaque pour former un 1-aza-3-cyclopentène-3 carboxamide de formule :

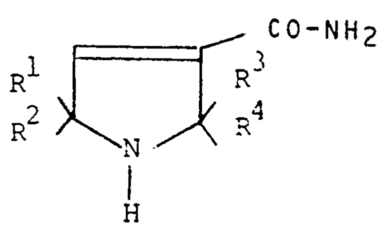

(IV)

puis on soumet ce 1-aza-3-cyclopentène-3-carboxamide à une dégradation d'Hoffmann par l'hypobromite de sodium pour former une 4-pyrrolidone de formule :

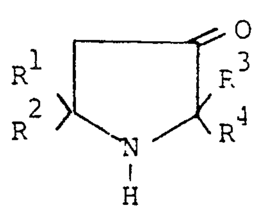

(V)

On soumet ensuite la 4-pyrrolidone à une deutération, par exemple par échange avec $D_2O$ en milieu

basique ($CO_3K_2$)pour former une 4-pyrrolidone de formule :

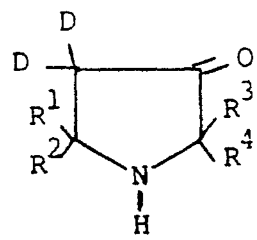

(VI)

puis on convertit la 4-pyrrolidone deutérée en pyrrolidine deutérée de formule

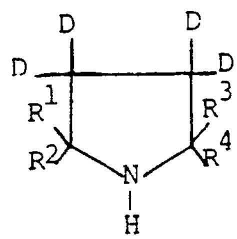

(VII)

par réaction de Wolf-Kishner, avec de l'hydrate d'hydrazine deutérée, par exemple en solution dans l'éther monoéthylique du diéthylène glycol.

On oxyde ensuite la pyrrolidine en pyrrolidine-1-oxyle de formule :

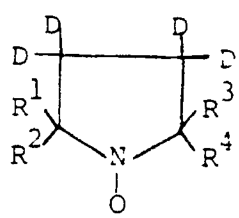

(I)

Cette oxydation peut être réalisée par exemple au moyen d'eau oxygénée en présence de phosphotungstate de sodium.

Le composé de départ, c'est-à-dire le bromhydrate de 3,5-dibromo-4-pipéridinone (III) peut être préparé à partir des cétones correspondantes par condensation de 3 molécules de cétone sur une molécule d'ammoniac. On soumet ensuite le produit obtenu, soit la pipéridinone de formule (VIII) :

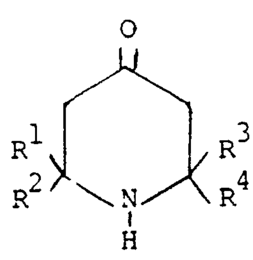

(VIII)

à un traitement par du brome dans l'acide acétique pour préparer le bromhydrate de formule (III).

Le schéma réactionnel correspondant à la préparation du radical nitroxyde de l'invention est donné ci-dessous :

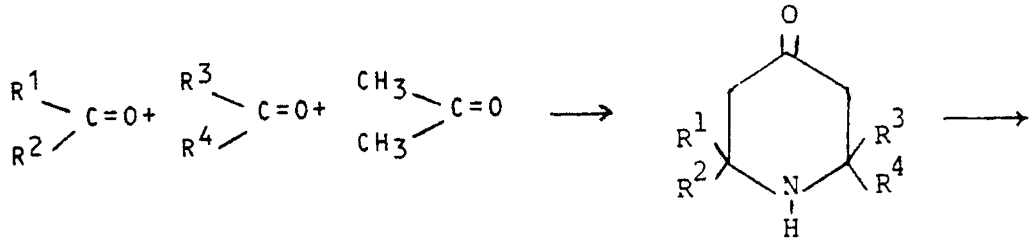

(VIII)

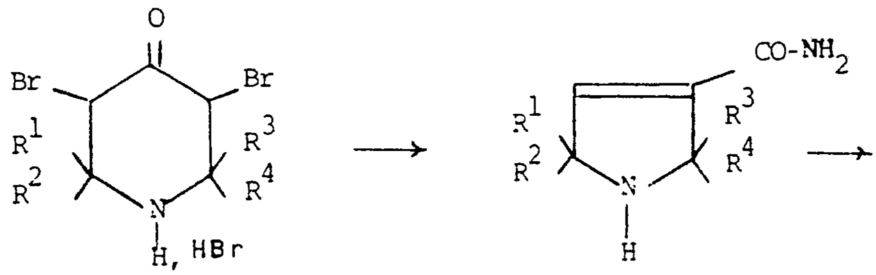

(III) (IV)

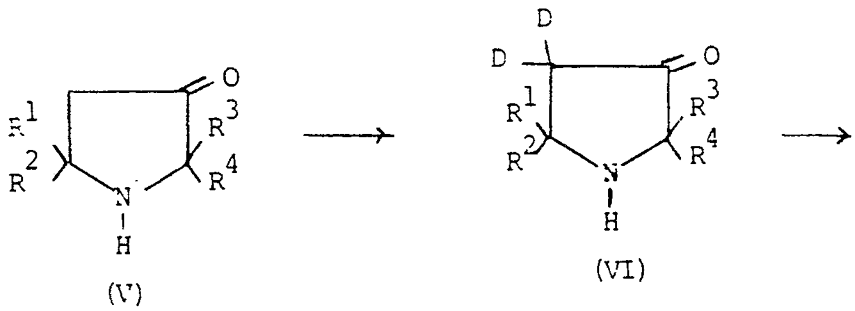

(V) (VI)

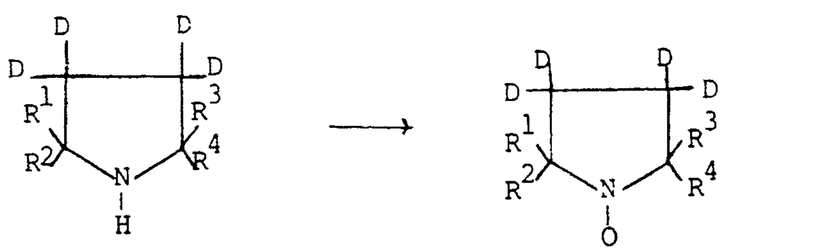

(VII) (I)

Dans le procédé de polarisation de l'invention, le radical nitroxyde utilisé présente l'avantage d'améliorer les performances de la polarisation dynamique sans détruire la stabilité en température qui est élevée, puisqu'on observe seulement une perte de 1,5% des caractéristiques spectrales RPE après 30 heures à 130 °C.

Toutefois, comme on l'a vu précédemment, les performances du magnétomètre sont également liées au couple solvant-radical libre.

En effet, pour une utilisation à des températures supérieures à 70 °C, il est préférable que le solvant ait un point d'ébullition supérieur à 70 °C, un faible coefficient de dilatation et un bon coefficient de polarisation dynamique tout en formant une solution stable avec le radical libre utilisé.

Les lois fondamentales de la polarisation dynamique montrent que la viscosité du solvant intervient

dans le facteur de polarisation dynamique (FPD) selon la formule suivante :

$$FPD \simeq \Delta HRPE \simeq C_1 + C_2 x + \frac{C_3}{x} + \frac{C_4}{x} + C_5 x \psi(A\sqrt{x})$$

dans laquelle ΔHRPE représente la largeur de raie RPE et x T/η avec η représentant la viscosité de la solution. Pour obtenir une valeur optimale du facteur de polarisation dynamique, il convient donc de choisir des solvants ayant une viscosité voisine de 1mPa.s à la température d'utilisation.

Selon l'invention, on peut utiliser l'eau comme solvant, car celle-ci offre un bon compromis entre la viscosité, le point d'ébullition, la taille moléculaire, la stabilité du radical dissous, le coefficient de dilatation, et le facteur de polarisation dynamique.

On peut aussi utiliser d'autres solvants tels que le tétrahydrofuranne, le glycérol, le dioxanne, le Diglyme (éther diméthylique du diéthylène glycol) et leurs mélanges ainsi que des mélanges de ces solvants avec de l'eau tels que les mélanges eau-Diglyme et eau-dioxanne.

En effet, de nombreux solvants présentent des points d'ébullition supérieurs à 120° C mais parmi ceux-ci, certains présentent une stabilité radicalaire mauvaise, un facteur de polarisation dynamique insuffisant ou une viscosité trop importante à faible température. Or, il suffit d'un seul de ces handicaps pour que la solution ne soit pas bonne pour la magnétométrie ou la gyrométrie.

Ainsi, des solvants tels que l'octanol, l'éthylène glycol, l'éther butylique, le butanol, le tridécane, le dodécane, l'hexadécane, le phtalate de dibutyle, le benzène, le propanediol, le 2-éthyl 1-hexanol, le stéarate de butyle, le sébaçate de dibutyle, le diéthylène glycol, le tétrahydroheptane, l'orthosilicate et le tétrahydropyrane, qui possèdent les propriétés voulues de résistance à des températures de 30 à 130° C, ne peuvent être utilisés dans l'invention parce qu'ils réagissent avec le radical nitroxyde et/ou conduisent à une polarisation insuffisante.

Aussi, selon l'invention, le solvant est de préférence l'eau, le Diglyme ou un mélange d'eau et d'un composé choisi parmi l'éther diméthylique du diéthylène glycol et le dioxanne, par exemple un mélange eau-Diglyme comprenant de 5 à 50% en volume de Diglyme.

Selon l'invention, on préfère en particulier les mélanges eau-Diglyme à 5% et 39% en volume de Diglyme, associés avec le radical nitroxyde de formule (II) dans laquelle N est $^{15}N$.

Généralement, la concentration en radical libre du solvant se situe dans la gamme de $8 \times 10^{-4}$ à $1{,}5 \times 10^{-3}$ mol/l.

Lorsqu'on utilise le radical nitroxyde de l'invention dans une sonde à double effet, c'est-à-dire une sonde comportant deux échantillons différents, tels que la résultante macroscopique des moments magnétiques des noyaux d'un des échantillons est opposée à la résultante macroscopique des moments magnétiques des noyaux de l'autre échantillon, l'un des échantillons peut être constitué par une solution de ce radical libre dans un solvant, et l'autre échantillon peut être constitué soit par une solution de ce radical libre dans un autre solvant, soit par une solution d'un autre radical libre dans le même solvant ou dans un solvant différent.

Aussi, l'invention a également pour objet une sonde de magnétomètre à résonance magnétique nucléaire sans axe interdit comprenant deux ensembles composés chacun d'une bobine entourant un premier ou un second échantillon, les bobines étant bobinées en sens contraire et les échantillons étant différents et tels que la résultante macroscopique des moments magnétiques des noyaux du premier échantillon soit opposée à la résultante macroscopique des moments magnétiques des noyaux du second échantillon lorsque les deux échantillons sont excités à la même fréquence, caractérisée en ce qu'au moins le premier échantillon est constitué par un radical nitroxyde de formule :

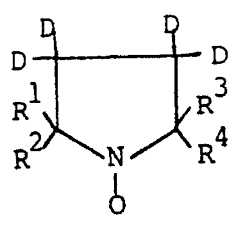

(I)

dans laquelle $R^1$, $R^2$, $R^3$ et $R^4$ qui peuvent être identiques ou différents, représentent un radical alkyle ou un radical alcoxy éventuellement deutéré, ou dans laquelle les couples $R^1$ - $R^2$ et/ou $R^3$ - $R^4$ forment ensemble

un radical cycloalkyle ou polycycloalkyle éventuellement deutéré, et N représente $^{14}N$ ou $^{15}N$, dissous dans un solvant choisi parmi l'eau, un mélange d'eau et de dioxane et un mélange d'eau et d'éther diméthylique du diéthylène glycol.

De préférence, dans le radical nitroxyde décrit ci-dessus, $R^1$, $R^2$, $R^3$ et $R^4$ représentent $CD_3$.

Lorsque les deux échantillons comprennent le même radical libre, par exemple le radical de formule :

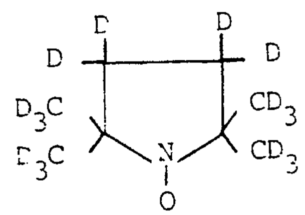

(II)

dans laquelle N est $^{14}N$ ou $^{15}N$, les deux échantillons peuvent être constitués par le même radical nitroxyde dissous dans un mélange d'eau et d'éther diméthylique du diéthylène glycol (Diglyme), la concentration en Diglyme du mélange eau-Diglyme du premier échantillon étant différente de la concentration en Diglyme du mélange eau-Diglyme du second échantillon.

Dans ce cas, avantageusement, la concentration en Diglyme du mélange du premier échantillon est de 5% en volume, et la concentration en Diglyme du mélange du second échantillon est de 39% en volume.

Lorsque les deux échantillons comprennent des radicaux libres différents, le second échantillon peut être constitué par le radical de formule :

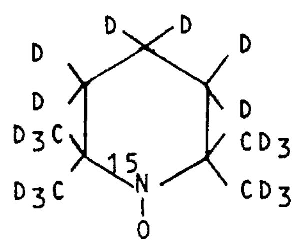

dissous dans un mélange d'eau et de tétrahydrofuranne ou dans un mélange eau-tétrahydrofuranne-glycérol.

D'autres caractéristiques et avantages de l'invention apparaîtront mieux à la lecture de la description qui suit donnée bien entendu à titre illustratif et non limitatif en référence au dessin annexé sur lequel :

- les figures 1 et 2 représentent schématiquement une sonde de magnétomètre sans axe interdit.

On décrit tout d'abord la préparation de radicaux nitroxydes utilisés dans l'invention répondant à la formule (II) dans laquelle N est un atome d'azote 14 (exemple 1) ou un atome d'azote 15 (exemple 2).

Le schéma réactionnel correspondant à ces préparations est celui donné précédemment avec $R^1 = R^2 = R^3 = R^4 = CD_3$.

**Exemple 1 :** Préparation de la 2,2,5,5-tétraméthyl pyrrolidine- d 16-1-oxyle de formule (II) avec $^{14}N$.

a) préparation de la triacétonamine-d 16 de formule (VIIIa).

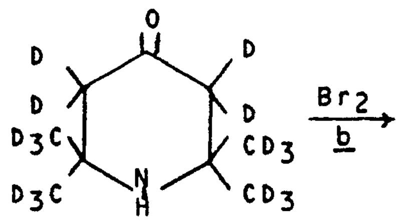


On introduit 5ml (0,31mol) d'acetone deutériée à 99,7% et 8g de chlorure de calcium (0,07mol) dans un autoclave de 125ml préalablement refroidi dans l'azote liquide. On ajoute alors 3,5ml d'ammoniac liquide $NH_3$ (0,12mol), puis on maintient l'autoclave à 50° C sous agitation pendant 24 heures. On place ensuite le produit de la réaction dans un ballon de 50cm$^3$ et on chauffe pendant 5 heures à 70° C. On laisse décanter et on recueille la phase liquide rouge brun. Après addition de 0,5 cm$^3$ d'eau et congélation à -15° C (mélange glace-sel), l'hydrate de triacétonamine précipite et on récupère ainsi 5,1g de cet hydrate, ce qui correspond à un rendement de 30%.

Ses caractéristiques sont les suivantes :

- point de fusion : 58° C,
- spectre infrarouge (IR(KBr):2220(CD) et 1700(C=0)).

b) Préparation du bromhydrate de 2,6-dibromotriacétonamine de formule (IIIa)

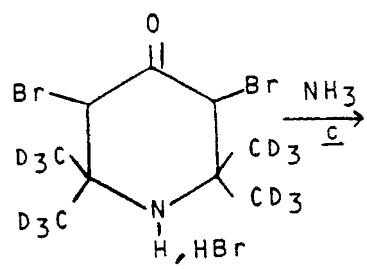


On verse goutte à goutte une solution de 50,5g de brome dans 30cm$^3$ d'acide acétique dans une solution agitée magnétiquement de 27g (0,13mol) d'hydrate de triacétonamine de formule (VIIIa) dans 30 cm$^3$ d'acide acétique. On laisse le mélange réactionnel pendant une nuit sous agitation, puis on lave à l'éther le bromhydrate qui a précipité, on le sèche à l'air et on récupère ainsi 50g du bromhydrate de formule (IIIa) sous la forme d'une substance blanche, ce qui correspond à un rendement de 90%.
Point de fusion (F :193-195° C).

c) Préparation du 2,2,5,5-tétraméthyl-$d_{12}$-4 pyrroline-3-carboxamide de formule (IVa).

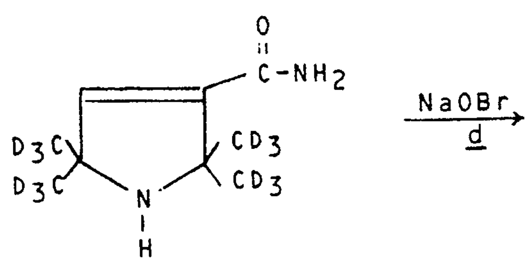


On ajoute sous forte agitation magnétique 50g (0,12mol) de bromhydrate de 2,6-dibromotriacétonamine par petites portions afin que la température ne dépasse pas 3 à 5° C, à 250ml de méthanol préalablement

saturé d'ammoniac. On chasse le méthanol, puis on dissout le résidu dans le minimum d'eau. Par addition de pastilles de soude à la solution, on précipite l'amide, on le filtre, on le sèche à l'air et on le cristallise dans le toluène. On récupère ainsi 16g du carboxamide de formule (IVa), ce qui correspond à un rendement de 70% (F = 177 ° C).

d) Préparation du 2,2,5,5-tétraméthyl-$d_{12}$-3-pyrrolidone de formule (Va).

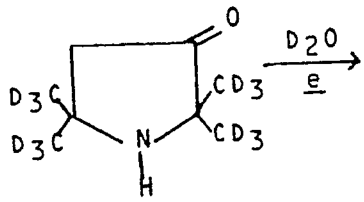


On ajoute par petites portions 16g (0,09 mol) de l'amide de formule (IVa) à une solution d'hypobromite de sodium préparé en ajoutant lentement 20g de brome à une solution de 25g de soude dissoute dans 175cm$^3$ d'eau, le mélange réactionnel étant refroidi par un bain (sel + glace), et l'on porte au reflux pendant 1 heure. La solution qui était incolore au départ devient jaune verdâtre, puis rouge orangé à la fin. Après refroidissement à la température ambiante, on ajoute 75g de soude et on entraîne la pyrrolidone de formule (Va) à la vapeur dans un ballon d'un litre contenant 30cm$^3$ d'acide chlorhydrique. L'entrainement à la vapeur est arrêté lorsqu'on a chassé 750cm$^3$ d'eau. L'eau est alors chassée, le résidu est dilué dans 60cm$^3$ de lessive de soude, et on extrait l'amine à l'éther, puis on la sèche sur du $K_2CO_3$ distillé. On récupère ainsi 6g de la pyrrolidone de formule (Va), ce qui correspond à un rendement de 40% (Eb sous 40mm de mercure = 80 ° C).

e) Préparation de la pyrrolidone deutérée de formule (VIa)

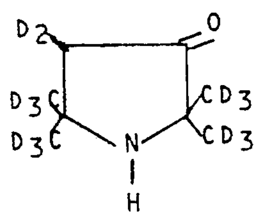

On met en contact 6g de la pyrrolidone de formule (Va) avec 30 cm$^3$ d'eau lourde en présence de 2g de $K_2CO_3$. On obtient ainsi 5,3g de pyrrolidone deutérée de formule (VIa), ce qui correspond à un rendement de 90%.

La deutération complète est observée par RMN. En effet, le pic des protons portés par le carbone en α du carbonyle (S = 2,3 dans $CDCl_3$) disparaît après ce traitement d'échange.

f) Préparation de 2,2,5,5-tétraméthyl-$d_{16}$ pyrrolidine de formule (VIIa).

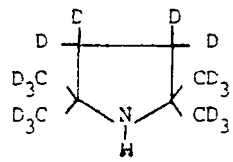

On chauffe à 135° C pendant 24 heures un mélange de

- 5,3g (0,033mol) de la pyrrolidone de formule (VIa).
- 27ml de monoéthyléther d'éthylène glycol qui a été traité 3 fois au reflux avec un volume égal d'eau lourde, l'eau lourde étant distillée après chaque opération, et
- 5,6g d'hydrate d'hydrazine deutérié, fraîchement distillé qui a été préparé en chauffant au reflux 7g d'hydrate d'hydrazine dans 30cm$^3$ d'eau lourde (échange répété 3 fois),
- avec 7,5g de KOD obtenu après 3 échanges de 10g de KOH dans 20cm$^3$ d'eau lourde.

On porte ensuite la température du mélange réactionnel à 195° C, puis on récupère la fraction qui distille. On la sature de $CO_3K_2$, on extrait la couche organique et on la distille. On récupère ainsi 2,3g de la pyrrolidine de formule (VIIa), ce qui correspond à un rendement de 45% (Eb 105° C).

g) Préparation du 2,2,5,5-tétraméthyl pyrrolidine-$d_{16}$-1-oxyle de formule (II).

On ajoute 3,25ml de $H_2O_2$ à 30% à une solution préalablement refroidie de 1,86g de la pyrrolidine de formule (VIIa) (10mmol), de 0,2g de Trilon B, de 3mg de tungstate de sodium dans 10cm$^3$ de méthanol à 45%. On laisse ensuite le mélange réactionnel pendant 10 jours à la température de la pièce. On le dilue alors dans 20cm$^3$ d'eau saturée au carbonate de potassium. On extrait alors la pyrrolidine, soit le radical de formule (II), à l'éther, on la sèche sur du sulfate de magnésium et on chasse l'éther. On récupère ainsi 0,9g du radical de formule (II), ce qui correspond à un rendement de 60%.

**Exemple 2 :** Préparation du radical de formule (II) avec N étant un atome d'azote 15.

On suit le même mode opératoire que dans l'exemple 1 sauf que dans l'étape a) on prépare la triacétonamine-$d_{16}$-$N^{15}$ de la façon suivante.

On ajoute 52,5g (0,82mol) d'acétone deutériée à 99,6% à un mélange de 40,32g (0,124mol) de carbonate de césium, de 5,23g (0,047mol) de chlorure de calcium anhydre pulvérisé, de 20g (0,247mol) de nitrate d'ammonium, $^{15}NH_3NO_3$ (teneur isotopique 99% CEA). On agite le mélange puis on l'abandonne pendant 20 jours à la température de la pièce avec agitation occasionnelle. On sépare alors la solution liquide, on lave le solide à l'éther, au chlorure de méthylène, puis on le décompose avec 50cm$^3$ de KOH à 50%. On extrait la suspension alcaline à l'éther, au chlorure de méthylène. On réunit les fractions organiques, puis on les sèche sur $CO_3K_2$. On chasse les solvants à froid et on distille le résidu sous vide. On cristallise dans l'hexanne la fraction passant entre 50 et 60° C sous 0,2mm de mercure. On récupère ainsi 13g de la triacétonamine-$d_{16}$-$N^{15}$, ce qui correspond à un rendement de 30%. (F:36° C).

On réalise ensuite les étapes b) à g) comme dans l'exemple 1, et l'on obtient ainsi le 2,2,5,5-tétraméthylpyrrolidine-$d_1$-1-oxyle-$^{15}N$.

Les radicaux nitroxydes préparés dans les exemples 1 et 2 associés à un solvant constitué par de l'eau, du Diglyme ou un mélange eau-Diglyme, présentent de très bonnes caractéristiques RPE pour une utilisation dans un magnétomètre, comme on pourra le voir dans le tableau qui suit où sont données les caractéristiques du spectre RPE de ces radicaux. On a porté également dans ce tableau les caractéristiques RPE de ces radicaux après avoir chauffé le solvant contenant ces radicaux pendant 17 à 40 heures à 130° C.

On constate ainsi que les caractéristiques RPE de ces radicaux ne sont que très peu modifiées.

Dans ce tableau, on a également donné les caractéristiques RPE de plusieurs radicaux nitroxydes de l'art antérieur, comportant un cycle à 5 atomes de carbone ou un cycle à 6 atomes de carbone, associés à un solvant constitué par de l'eau ou à des solvants usuels tels que l'octanol et l'éthylène glycol.

Dans tous les cas, la concentration en radical libre du solvant est de $10^{-3}$mol/l.

Comme on peut le voir sur ce tableau, le cycle à 6 atomes de carbone deutéré et à azote-15 ne résiste pas au chauffage car l'amplitude du signal RPE (hauteur de la raie) diminue de façon importante après

chauffage, notamment avec les solvants usuels (éthylène glycol et octanol).

T A B L E A U

| Radical ($10^{-3}$mol/l) | Solvant | Chauffage | Ecart hyperfin An (gauss) | Largeur de raie $H_{RE}$ (gauss) | Hauteur de la raie centrale (cm) | Gain du spectromètre RPE |
|---|---|---|---|---|---|---|
| 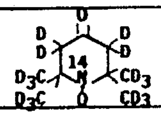 | tétrahydro-furanne (THF) | sans<br>17h à 130°C | 14,583<br>14,583 | 0,376<br>0,255 | 24,1±0,5<br>11,5±0,5 | $4.10^4$<br>$4.10^4$ |
| 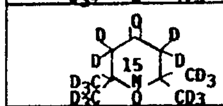 | $H_2O$ | sans<br>40h à 130°C | 22,51<br>22,57 | 0,26<br>0,19 | 19±0,5<br>18,4±0,5 | $6,3.10^3$<br>$4.10^4$ |
| 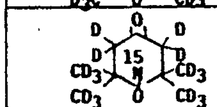 | Ethylène glycol | sans<br>2h à 130°C | 21,64<br>21,64 | 0,29 | 22,9<br>3,6 | $10^4$<br>$10^4$ |
| 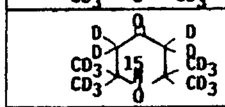 | Octanol | sans<br>27h à 130°C | 21,10<br>21,10 | 0,29<br>0,27 | 19,3<br>1,4 | $2.10^4$<br>$2.10^4$ |
| 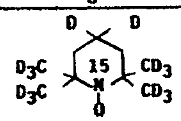 | $H_2O$-THF (90/10) | sans<br>5h à 130°C<br>23h à 130°C | 24,125<br>24,125<br>24,125 | 0,524<br>0,524<br>0,511 | 18,8±0,5<br>18,5±0,5<br>16,4±0,5 | $3,2.10^4$<br>$3,2.10^4$ |
| 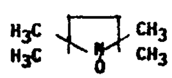 | $H_2O$ | sans<br>33h à 130°C | 16,42<br>16,42 | 0,59<br>0,59 | 19±0,5<br>18,3±0,5 | $4.10^4$<br>$4.10^4$ |
| 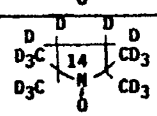 | $H_2O$ | sans<br>10h à 130°C<br>16h30 à 140°C | 16,397<br>16,397 | 0,349<br>0,349 | 26,2±0,5<br>25,7±0,5<br>24,8±0,5 | $2,5.10^4$<br>$2,5.10^4$ |

../

TABLEAU (suite)

| Radical ($10^{-3}$mol/l) | Solvant | Chauffage | Ecart hyperfin An (gauss) | Largeur de raie $H_{RE}$ (gauss) | Hauteur de la raie centrale (cm) | Gain du spectromètre RPE |
|---|---|---|---|---|---|---|
| 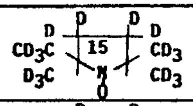 | $H_2O$ | sans<br>40h à 130°C | 22,96<br>22,96 | 0,30<br>0,30 | 27,7±0,5<br>27,1±0,5 | $1,25.10^4$<br>$1,25.10^4$ |
| 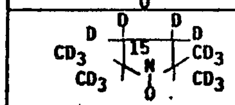 | Diglyme | sans<br>40h à 130°C | 16,297<br>16,297 | 0,35<br>0,35 | 26,6<br>25,8 | $2.10^4$<br>$2.10^4$ |
| 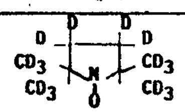 | $H_2O$ +<br>Diglyme | sans<br>40h à 130°C | 14,45<br>14,45 | 0,51<br>0,51 | 17,6<br>17,1 | $2,5.10^4$<br>$2,5.10^4$ |

En revanche, le radical nitroxyde utilisé dans l'invention avec un solvant constitué par de l'eau, l'éther diméthylique du diéthylène glycol (Diglyme) ou un mélange eau-Diglyme, résiste beaucoup mieux au chauffage et présente des caractéristiques supérieures à celles des radicaux avec un cycle à 6 atomes de carbone, notamment lorsque le radical est complètement deutéré et contient de l'azote-15.

Ainsi, les radicaux nitroxydes de l'invention peuvent être utilisés à des températures allant jusqu'à 130 °C dans un magnétomètre à résonance magnétique nucléaire tel que celui décrit dans FR-A- 2 098 624.

Sur les figures 1 et 2, on a représenté une sonde d'un magnétomètre sans axe interdit.

Sur la figure 1, on a représenté une coupe schématique d'une sonde. La sonde est constituée de deux ensembles similaires 2 et 4, alignés suivant l'axe ZZ′ ; chaque ensemble se compose d'une bobine 6 ou 6′ entourant un premier échantillon 8 ou un second échantillon 8′ ; la section droite des bobines 6 et 6′ peut être notamment triangulaire ; les échantillons sont contenus dans deux récipients indépendants 10 et 10′ qui peuvent avantageusement avoir la forme de deux flacons symétriques, respectivement 14 et 15, et 14′ et 15′, de sorte que, juxtaposés, ils délimitent un espace dans lequel les bobines 6 et 6′ peuvent être disposées. La cavité résonnante d'excitation comprend un conducteur 12 relié au conducteur initial du câble coaxial 13 et une enveloppe extérieure 18.

Dans les sondes uniaxiales telles que celle qui est représentée sur la figure 1, les bobines 6 et 6′ sont bobinées en sens contraire de sorte que les signaux parasites qui y sont induits se compensent mutuellement ; au contraire, les signaux utiles provenant des forces électromotrices créées par les phénomènes de résonances nucléaire s'ajoutent. Un tel bobinage est illustré sur la figure.2.

Il est à noter que le résultat ci-dessus n'est toutefois atteint que si la résultante macroscopique des moments magnétiques des noyaux du premier échantillon est opposée à la résultante macroscopique des moments magnétiques des noyaux du second échantillon. Dans le mode de réalisation illustré, comportant une seule source d'excitation à très haute fréquence, il faut que ces effets opposés interviennent en réponse à une excitation qui s'effectue à la même fréquence pour les deux échantillons.

Pour obtenir un tel résultat, on peut, par exemple utiliser le même radical dans les deux échantillons mais des solvants différents.

Dans ce cas, le premier échantillon (8) peut être constitué par le radical nitroxyde de formule (II) de l'invention à azote 14 ou à azote 15, par exemple à une concentration de $10^{-3}$ mol/l dans de l'eau, et
- le second échantillon (8′) peut être constitué par le même radical nitroxyde de formule (II), par exemple à une concentration de $10^{-3}$mol/l, dans

1°) un mélange d'eau et de dioxanne (par exemple 55/45 en volume), ou

2°) un mélange d'eau et de Diglyme (par exemple 56/44 en volume).

On peut encore utiliser :
- un premier échantillon (8) constitué par une solution du radical nitroxyde de l'exemple 1 ou de l'exemple 2, par exemple à une concentration de $10^{-3}$mol/l, dans un mélange d'eau et de Diglyme (95 /5 en volume), et
- un second échantillon (8′) constitué par une solution du radical nitroxyde de l'exemple 1 ou de l'exemple 2, par exemple à une concentration de $10^{-3}$mol/l, dans un mélange d'eau et de Diglyme (61:39 en volume).

Dans le cas de la sonde uniaxiale à deux échantillons 8 et 8′ des figures 1 et 2, on peut encore utiliser
- pour le premier échantillon (8) le radical nitroxyde de formule (II) à azote 14 ou azote 15 en solution dans l'eau, par exemple à une concentration de $10^{-3}$mol/l, et
- pour l'échantillon (8′) d'autres radicaux et d'autres solvants à condition qu'ils soient stables aux températures utilisées. A titre d'exemple, le second échantillon (8′) pourrait être constitué dans ce cas par

1°) une solution de TANANE 2,2,6,6-tétraméthyl-pipéridine-1-oxyle deutérée à l'azote 15, par exemple à une concentration de $10^{-3}$mol/l dans un mélange d'eau et de tétrahydrofuranne, (par exemple 88/12 en volume) ou

2°) une solution de TANANE deutérée à l'azote 15, par exemple à une concentration de $10^{-3}$mol/l, dans un mélange eau-tétrahydrofuranne-glycérol (par exemple 70/10/20 en volume).

Tous les couples d'échantillons mentionnés ci-dessus permettent la réalisation de sondes opérationnelles d'un diamètre de 40mm, ayant une gamme de fonctionnement comprise entre 42 °C et 125 °C et dont la perte maximale est inférieure à 20% après 50 heures à 125 °C.

Les solvants utilisés ont un coefficient de dilatation inférieur au méthanol et au diméthoxyéthane couramment utilisés dans les sondes classiques. De ce fait, on peut conserver une bulle de dilatation de 10 à 15%. La pression dans les flacons de verre ne dépassera pas 0,25MPa à 125 °C, pression à laquelle ils peuvent résister.

## Revendications

1. Procédé de polarisation magnétique en champ faible des noyaux d'un solvant à une température de 30 à 130 ° C, par saturation d'une raie de résonance magnétique électronique d'un radical libre à structure spectrale hyperfine dissous dans ce solvant, en magnétométrie et en gyrométrie, caractérisé en ce que le radical libre est un radical nitroxyde répondant à la formule :

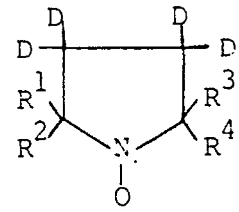

(I)

dans laquelle $R^1$, $R^2$, $R^3$ et $R^4$ qui peuvent être identiques ou différents, représentent un radical alkyle ou un radical alcoxy éventuellement deutéré, où dans laquelle les couples $R^1$ - $R^2$ et/ou $R^3$ -$R^4$ forment ensemble un radical cycloalkyle ou polycycloalkyle éventuellement deutéré, et- N représente $^{14}N$ ou $^{15}N$.

2. Procédé selon la revendication 1, caractérisé en ce que $R^1$, $R^2$, $R^3$ et $R^4$ représentent un radical alkyle deutéré de 1 à 4 atomes de carbone.

3. Procédé selon la revendication 2, caractérisé en ce que le radical nitroxyde répond à la formule (II)

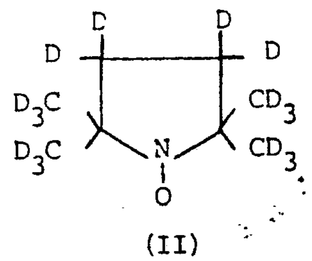

(II)

dans laquelle N est $^{15}N$.

4. Procédé selon la revendication 2, caractérisé en ce que le radical nitroxyde répond à la formule (II)

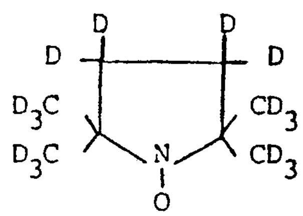

(II)

dans laquelle N est $^{14}N$.

5. Procédé selon l'une quelconque des revendications 1 à 4, caractérisé en ce que le solvant est l'eau ou l'éther diméthylique du diéthylène glycol.

6. Procédé selon l'une quelconque des revendications 1 à 4, caractérisé en ce que le solvant est un mélange d'eau et d'un composé choisi parmi l'éther diméthylique du diéthylène glycol et le dioxanne.

7. Procédé selon la revendication 6, caractérisé en ce que le solvant est un mélange d'eau et d'éther diméthylique du diéthylène glycol comprenant 5 à 50% en volume d'éther diméthylique du diéthylène glycol.

8. Procédé selon la revendication 3, caractérisé en ce que le solvant est un mélange d'eau et d'éther diméthylique du diéthylène glycol comprenant 5% ou 39% en volume d'éther diméthylique du diéthylène glycol.

9. Procédé de préparation d'un radical nitroxyde de formule :

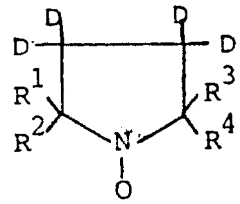

(I)

dans laquelle
- $R^1$, $R^2$, $R^3$ et $R^4$ qui peuvent être identiques ou différents, représentent un radical alkyle ou un radical alcoxy éventuellement deutéré, où dans laquelle les couples $R^1$ - $R^2$ et/ou $R^3$ - $R^4$ forment ensemble un radical cycloalkyle ou polycycloalkyle, et
- N est $^{14}N$ ou $^{15}N$,
caractérisé en ce qu'il comprend les étapes successives suivantes :
a) soumettre un bromhydrate de 3,5-dibromo4-pipéridinone de formule :

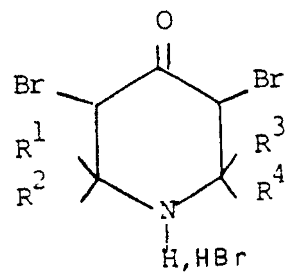

(III)

dans lequel $R^1$, $R^2$, $R^3$, $R^4$ et N ont la signification donnée ci-dessus à un réarrangement de Favorsky dans l'ammoniaque pour former un 1-aza-3-cyclopentène-3-carboxamide de formule :

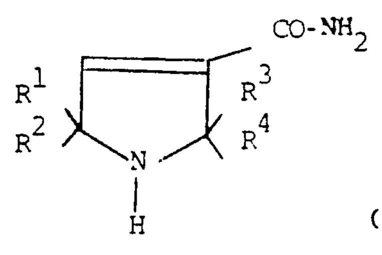

(IV)

b) soumettre le 1-aza-3-cyclopentène-3 carboxamide à une dégradation d'Hoffmann par l'hypobromite de sodium pour former une 4-pyrrolidone de formule :

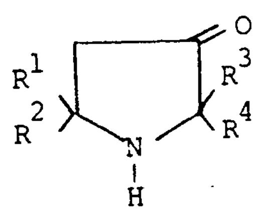

(V)

c) soumettre la 4-pyrrolidone à une deutération pour obtenir la 4-pyrrolidone deutérée de formule :

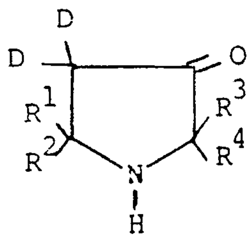

(VI)

d) convertir la 4-pyrrolidone deutérée en pyrrolidine deutérée de formule :

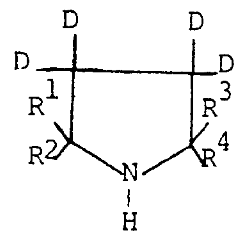

(VII)

par réaction de Wolf-Kishner avec de l'hydrate d'hydrazine deutérée, et
c) oxyder la 4-pyrrolidine en 4-pyrrolidine-1-oxyle de formule :

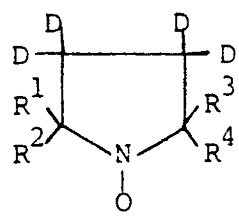

(I)

10. Procédé selon la revendication 9, caractérisé en ce que l'on prépare le bromhydrate de formule par
a) condensation de trois molécules de cétone de formule :

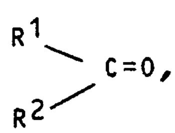,

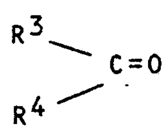 et

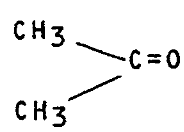

sur une molécule de $NH_3$ pour former une 4-pipéridinone de formule :

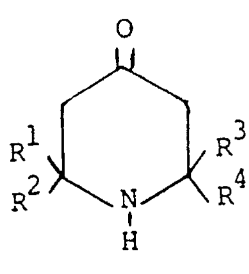

(VIII)

b) traitement de la 4-pipéridinone ainsi obtenue avec du brome en présence d'acide acétique.

11. Sonde de magnétomètre à résonance magnétique nucléaire sans axe interdit comprenant deux ensembles composés chacun d'une bobine (6 ou 6′) entourant un premier ou un second échantillon (8 ou 8′), les bobines (6) et (6′) étant bobinées en sens contraire et les échantillons (8) et (8′) étant différents et tels que la résultante macroscopique des moments magnétiques des noyaux du premier échantillon soit opposée à la résultante macroscopique des moments magnétiques des noyaux du second échantillon lorsque les deux échantillons sont excités à la même fréquence, caractérisée en ce qu'au moins le premier échantillon (8) est constitué par un radical nitroxyde de formule :

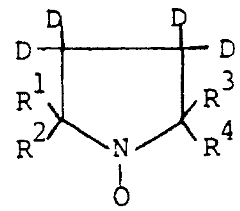

(I)

dans laquelle $R^1$, $R^2$, $R^3$ et $R^4$ qui peuvent être identiques ou différents, représentent un radical alkyle ou un radical alcoxy éventuellement deutéré, ou dans laquelle les couples $R^1$-$R^2$ et/ou $R^3$-$R^4$ forment ensemble un radical cycloalkyle ou polycycloalkyle éventuellement deutéré, et N représente $^{14}N$ ou $^{15}N$, dissous dans un solvant choisi parmi l'eau, un mélange d'eau et de dioxanne et un mélange d'eau et d'éther diméthylique du diéthylène glycol.

12. Sonde selon la revendication 11, caractérisée en ce que $R^1$, $R^2$, $R^3$ et $R^4$ représentent $CD_3$.

13. Sonde selon la revendication 12, caractérisée en ce que les premier et second échantillons (8)et (8′) sont constitués par le même radical nitroxyde dissous dans un mélange d'eau et d'éther diméthylique du diéthylène glycol (Diglyme), la concentration en Diglyme du mélange eau-Diglyme du premier échantillon étant différente de la concentration en Diglyme du mélange eau-Diglyme du second échantillon.

14. Sonde selon la revendication 13, caractérisée en ce que la concentration en Diglyme du mélange du premier échantillon est de 5% en volume, et la concentration en Diglyme du mélange du second échantillon est de 39% en volume.

15. Sonde selon l'une quelconque des revendications 11 et 12, caractérisée en ce que le second échantillon (8′) est constitué par le radical de formule :

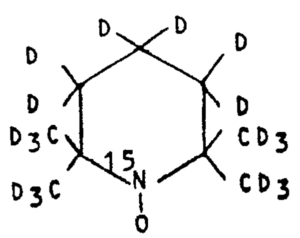

dissous dans un mélange d'eau et de tétrahydrofuranne ou dans un mélange eau-tétrahydrofuranne-glycérol.

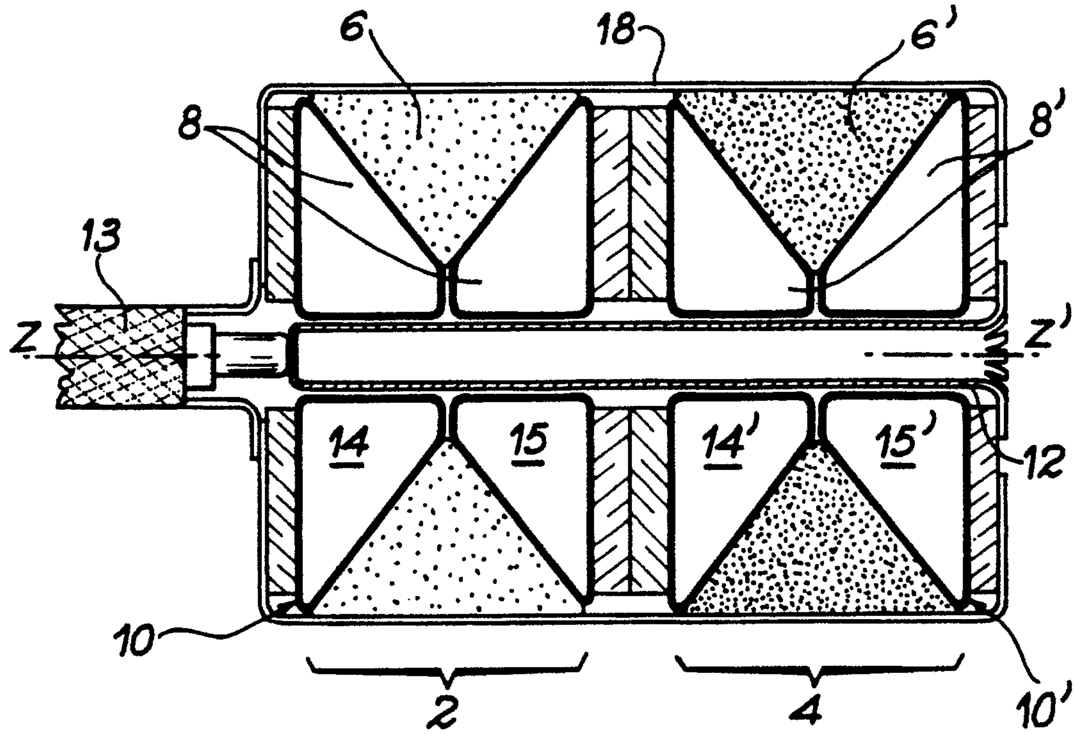


FIG. 1

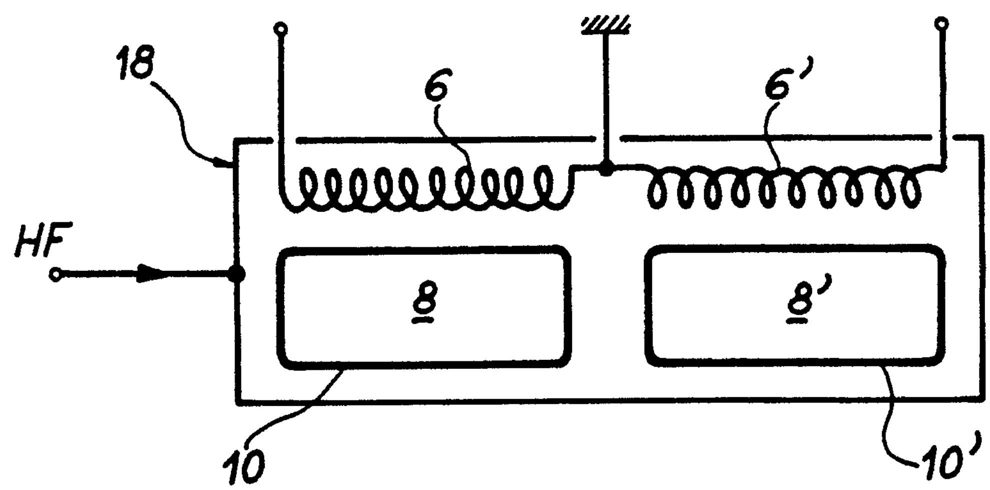


FIG. 2

Office européen des brevets

# RAPPORT DE RECHERCHE EUROPEENNE

Numéro de la demande

**EP 90 40 2842**

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| D,A | EP-A-0 185 825 (COMMISSARIAT A L'ENERGIE ATOMIQUE) * Revendications * | 1-15 | G 01 R 33/24<br>G 01 C 19/60<br>C 07 B 61/02<br>C 07 D 207/46 |
| D,A | FR-A-1 376 628 (COMMISSARIAT A L'ENERGIE ATOMIQUE) * En entier * | 1-15 | |

DOMAINES TECHNIQUES RECHERCHES (Int. Cl.5)

C 07 B 61/00
C 07 D 207/00

Le présent rapport de recherche a été établi pour toutes les revendications

| Lieu de la recherche | Date d'achèvement de la recherche | Examinateur |
|---|---|---|
| La Haye | 28 janvier 91 | WRIGHT M.W. |

CATEGORIE DES DOCUMENTS CITES

- X : particulièrement pertinent à lui seul
- Y : particulièrement pertinent en combinaison avec un autre document de la même catégorie
- A : arrière-plan technologique
- O : divulgation non-écrite
- P : document intercalaire
- T : théorie ou principe à la base de l'invention
- E : document de brevet antérieur, mais publié à la date de dépôt ou après cette date
- D : cité dans la demande
- L : cité pour d'autres raisons
- & : membre de la même famille, document correspondant